(19) Europäisches Patentamt
European Patent Office
Office européen des brevets

(11) **EP 1 033 580 B1**

(12) **EUROPÄISCHE PATENTSCHRIFT**

(45) Veröffentlichungstag und Bekanntmachung des Hinweises auf die Patenterteilung:
**05.01.2005 Patentblatt 2005/01**

(51) Int Cl.⁷: **G01R 21/06**, G01R 35/04, G01R 22/00

(21) Anmeldenummer: **00104232.4**

(22) Anmeldetag: **01.03.2000**

(54) **Elektrizitätszähler**

Electricity meter

Compteur d'électricité

| | |
|---|---|
| (84) Benannte Vertragsstaaten:<br>**AT BE CH CY DE DK ES FI FR GB GR IE IT LI LU MC NL PT SE** | (72) Erfinder: **Zintl, Peter**<br>**93092 Friesheim (DE)** |
| (30) Priorität: **02.03.1999 DE 19908901** | (74) Vertreter: **Graf, Helmut, Dipl.-Ing. et al**<br>**Patentanwalt**<br>**Postfach 10 08 26**<br>**93008 Regensburg (DE)** |
| (43) Veröffentlichungstag der Anmeldung:<br>**06.09.2000 Patentblatt 2000/36** | (56) Entgegenhaltungen:<br>**EP-A- 0 046 024     EP-A- 0 887 650**<br>**WO-A-97/04321     US-A- 3 293 497**<br>**US-A- 3 949 272** |
| (73) Patentinhaber: **ITF-EDV Fröschl GmbH**<br>**93194 Walderbach (DE)** | |

**Beschreibung**

Die Erfindung bezieht sich auf einen Elektrizitätszähler gemäß Oberbegriff Patentanspruch 1.

Elektrizitätszähler zum Messen des Verbrauchs an elektrischer Energie (Wirkarbeit) sowie ggfs. auch des Blind-Verbrauchs (Blindarbeit) sind in unterschiedlichster Ausführung bekannt. Der Einsatz von Elektrizitätszählern im geschäftlichen Verkehr erfordert nach dem Eichgesetz vor allem zum Schutze des Kunden eine Eichung des jeweligen Zählers zur Sicherstellung der Meßrichtigkeit und Meßbeständigkeit. Die Eichung (auch Beglaubigung) erfolgt durch staatlich anerkannte Prüfstellen, wobei nur Zähler, die über eine Bauartzulassung verfügen, eichfähig und damit für den Einsatz im geschäftlichen Verkehr geeignet sind. Die Bauartzulassung bestimmt dann unter Berücksichtigung technischer Kriterien des jeweiligen Zählers auch die Dauer für die Gültigkeit der Eichung (Eichgültigkeit), d.h. die Festlegung der Dauer der Eichgültigkeit für einen Elektrizitätszähler erfolgt nach der aufgrund seiner technischen Ausführung zu erwartenden Meßbeständigkeit. Nach Ablauf dieser Eichgültigkeit muß bisher jeder gewerblich genutzte Elektrizitätszähler geprüft und nachgeeicht werden, und zwar selbst dann, wenn der Zähler tatsächlich noch voll funktionsfähig ist.

Bekannt ist ein Elektrizitätszähler (WO 97/04321), der für eine Selbstüberwachung seiner Messkanäle so ausgebildet ist, dass die zu messenden Größen Strom und Spannung jeweils mehrfach über unterschiedliche Signal- oder Meßkanäle erfasst werden. In einer nachfolgenden, digitalen Signalverarbeitungseinrichtung erfolgt dann eine Plausibilitätsüberwachung der Meßwerte und bei einem Auftreten von Fehlern die Erzeugung eines Fehlersignals. Die Selbstüberwachung erfolgt bei diesem bekannten Elektrizitätszähler also dadurch, dass jede Messgröße (Strom und Spannung) jeweils wenigstens zweimal in zwei unterschiedlichen Messkanälen erfasst wird und die gewonnenen Ergebnisse verglichen werden. Allein die zweifache Erfassung jeder Messgröße in unterschiedlichen Signalkanälen bedeutet einen erhöhten Aufwand.

Bekannt ist weiterhin ein Elektrizitätszähler (EP 0 887 650 A1), bei dem das Drehfeld eines Drei- oder Vier-Leitersystems überwacht und ein unzutreffendes, beispielsweise durch Vertauschend er Anschlüsse erzeugtes Drehfeld angezeigt wird.

Bekannt sind ferner Schutzeinrichtungen (US-A-3 293 497 und US-A-3 949 272) zur Registrierung von Fehlerströmen in geerdeten Anlageteilen oder Leitungen. Bei diesem bekannten Stromschutzeinrichtungen handelt es sich nicht um Zähler, auch nicht um Einrichtungen zur Überwachung der Messrichtigkeit eines Elektrizitätszählers.

Aufgabe der Erfindung ist es, einen Elektrizitätszähler aufzuzeigen, der in besonders einfacher Weise eine Überprüfung seiner Funktionstüchtigkeit ermöglicht und damit auch eine einfache und zuverlässige Anzeige eines eventuellen Gerätefehlers. Zur Lösung dieser Aufgabe ist ein Elektrizitätszähler entsprechend dem Patentanspruch 1 ausgebildet.

Bei dem erfindungsgemäßen Elektrizitätszähler erfolgt eine Selbstprüfung. Der Hinweis auf einen Gerätefehler wird dann veranlaßt, wenn wenigstens eines der beiden Prüfsignale von dem zugehörigen Sollwert stärker abweicht, als dies durch einen vorgegebenen Toleranzbereich zulässig ist. Dieser Toleranzbereich ist beispielsweise so gewählt, daß schon Abweichungen zu dem Hinweis auf einen Gerätefehler führen, die größer sind als Abweichungen, die von den Nenn-Meß-Fehlern des Meßwerkes bedingt sind, d.h. von Meßfehlern, die das voll funktionsfähige Meßwerk naturgemäß aufweist.

Bei dem erfindungsgemäßen Elektrizitätszähler erfolgt die Bildung der Prüfsignale beispielsweise permanent oder aber zu vorgegebenen oder vorgewählten Zeitpunkten.

Unter Elektrizitätszähler" ist im Sinne der Erfindung grundsätzlich jede Einrichtung zu verstehen, mit der die für die Bestimmung des Verbrauchs an elektrischer Energie notwendigen Meßgrößen unter Berücksichtigung der Phasenwinkel zwischen Spannungen und Strömen bei einer Dreiphasen-Vierleiteranlage gemessen werden.

Weiterbildungen der Erfindung sind Gegenstand der Unteransprüche. Die Erfindung wird im Folgenden anhand der Figuren an einem Ausführungsbeispiel näher erläutert. Es zeigen:

Fig. 1      in vereinfachter schematischer Darstellung einen Elektrizitätszähler für Dreiphasen-Vierleiter-Anlagen;

Fig. 2      das Vektordiagramm der Spannungen und Ströme an den Anschlüssen bzw. Klemmen des Elektrizitätszählers der Figur 1.

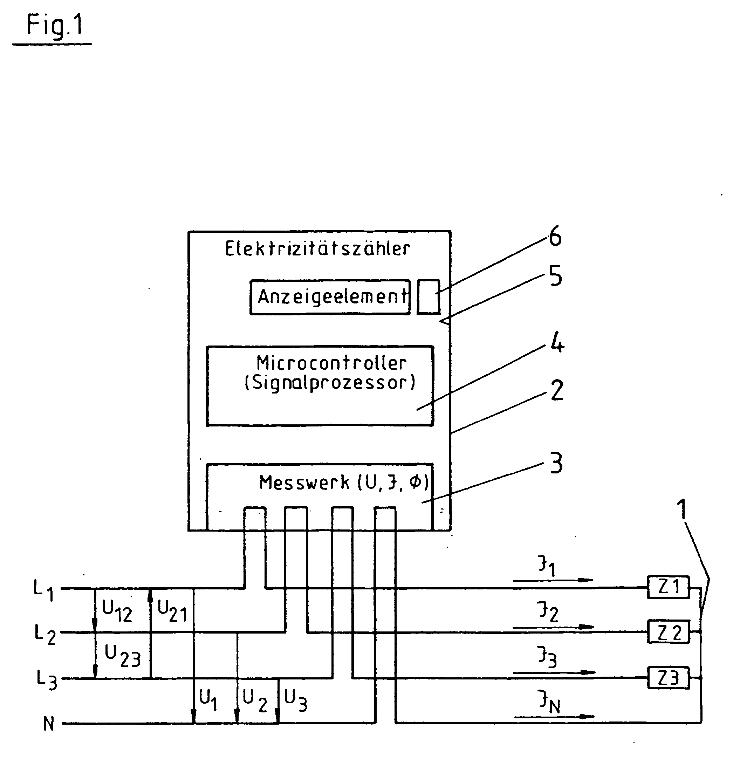

In der Figur 1 sind mit $L_1$, $L_2$ und $L_3$ die drei Phasen bzw. Phasen-Leiter und mit N der Null-Leiter einer Dreiphasen-Vierleiteranlage bezeichnet. Mit $Z_1$, $Z_2$ und $Z_3$ sind drei Verbraucher bezeichnet, die beispielsweise komplexe Lasten oder Impedanzen bilden und jeweils zwischen einer Phase bzw. einem der Leiter $L_1$ - $L_3$ und einem gemeinsamen Sternpunkt 1 liegen, der mit dem Null-Leiter N verbunden ist.

In den Figuren sind weiterhin folgende Spannungen und Ströme angegeben:

$U_1$ - Phasenspannung zwischen $L_1$ und N
$U_2$ - Phasenspannung zwischen $L_2$ und N
$U_3$ - Phasenspannung zwischen $L_3$ und N
$U_{12}$ - Außenspannung zwischen $L_1$ und $L_2$
$U_{23}$ - Außenspannung zwischen $L_2$ und $L_3$
$U_{31}$ - Außenspannung zwischen $L_3$ und $L_1$
$I_1$ - Strom im Leiter $L_1$ bzw. durch die Last $Z_1$
$I_2$ - Strom im Leiter $L_2$ bzw. durch die Last $Z_2$
$I_3$ - Strom im Leiter $L_3$ bzw. durch die Last $Z_3$

IN - Strom im Null-Leiter N.

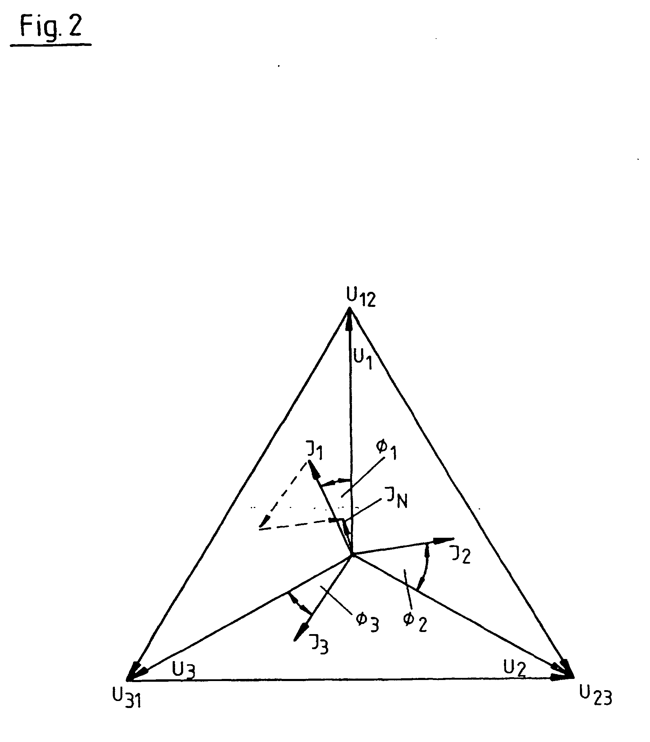

Wie das Vektordiagramm der Figur 2 zeigt, sind die Spannungen $U_1$, $U_2$ und $U_3$ in üblicher Weise um 120° phasenverschoben. Eine entsprechende Phasenverschiebung besteht auch zwischen den Außenspannungen $U_{12}$, $U_{23}$ und $U_{31}$. Die Ströme $I_1$, $I_2$ und $I_3$ sind jeweils in ihrer Größe abhängig von der Last $Z_1$ - $Z_3$ und entsprechend dem Blindanteil dieser Last gegenüber der zugehörigen Spannung um den Phasenwinkel $\phi_1$, $\phi_2$ bzw. $\phi_3$ verschoben.

Die an den Lasten $Z_1$ - $Z_3$ anliegenden Spannungen entsprechen jeweils der Spannung $U_1$, $U_2$ bzw. $U_3$.

Zur Bestimmung des Verbrauchs an Wirkleistung (Wirkarbeit), aber auch beispielsweise zur Bestimmung des Verbrauchs an Blindleistung (Blindarbeit) dient der Elektrizitätszähler 2, welcher mit den Anschlüssen seines Meßwerkes 3 in die Phasenleiter $L_1$ - $L_3$ sowie in den Null-Leiter N eingeschleift ist, d.h. diese Leiter führen über das Meßwerk 3, mit dessen Hilfe zumindest die Phasenspannungen $U_1$ - $U_3$ und deren Phasenwinkel $\phi$, die Ströme $I_1$ - $I_2$ und deren Phasenwinkel $\phi$ sowie den Strom IN und dessen Phasenlage relativ zu wenigstens einer der Spannungen $U_1$ - $U_3$ gemessen bzw. bestimmt werden. Aus den Spannungen $U_1$ - $U_3$ und den zugehörigen Strömen $I_1$ - $I_3$ können dann unter Berücksichtigung der Phasenwinkel die Wirkleistung P und Blindleistung Q nach den dem Fachmann bekannten Bedingungen und hieraus die jeweilige Wirkarbeit A = ∫P dt bzw. die Blindarbeit R = ∫Q dt in einem Microcontroller bzw. Signalprozessor 4 des Elektrizitätszählers gebildet und abgespeichert und/oder an einem Anzeigeelement 5 angezeigt werden.

Das Meßwerk 3 ist bei der dargestellten Ausführungsform ein elektronisches Meßwerk, mit welchen die gemessenen Größen als aufbereitete Meßwerte über entsprechende Analog-Digital-Wandler dem Microcontroller 4 zugeführt werden, der aus diesen Meßgrößen auch die Phasenwinkel bzw. die Phasenlage bestimmt.

Eine Besonderheit des Elektrizitätszählers 2 besteht darin, daß im Microcontroller 4 auch die Außenspannungen $U_{12}$, $U_{23}$ und $U_{31}$ als Vektoren aus den gemessenen Phasenspannungen $U_1$, $U_2$ und $U_3$ gebildet werden und daß ständig oder aber in vorgegebenen oder vorgewählten Zeitintervallen eine geometrische oder vektorielle Addition dieser Außenspannungen sowie auch eine geometrische bzw. vektorielle Addition der gemessenen Ströme $I_1$, $I_2$, $I_3$ und $I_N$ erfolgt. Die Meßgrößen sind dabei digitale Werte bzw. werden digital verarbeitet.

Die jeweilige Messung durch das Meßwerk 3 ist korrekt, wenn sowohl die geometrische Summe aller Ströme als auch die geometrische Summe sämtlicher Außenspannungen jeweils Null ist, d.h. die folgenden Bedingungen gelten:

(I) $\quad I_1 + I_2 + I_3 + I_N = \text{Null}$

(II) $\quad U_{12} + U_{23} + U_{31} = \text{Null}.$

Sind die beiden vorgenannten Bedingungen erfüllt, so ist dies ein Indiz für ein einwandfreies Arbeiten des Elektrizitätszählers 2, d.h. ein Austauschen und Nacheichen des Elektrizitätszählers ist dann nicht erforderlich.

Ist eine der beiden Bedingungen (I)/(II) nicht erfüllt, so bedeutet dies einen Gerätefehler, der über den Microcontroller 4 an der Anzeige 5, beispielsweise an einem speziell hierfür vorgesehenen Segment 6 dieser Anzeige angezeigt wird. Grundsätzlich besteht auch die Möglichkeit, diesen Gerätefehler über eine Datenfernübertragung an eine zentrale Überwachungsstation zu melden, von der aus dann zum Kundenschutz der defekte Elektrizitätszähler gegen einen neuen nachgeeichten Elektrizitätsfehler 2 ausgetauscht wird.

Da mit der erfindungsgemäßen Ausbildung Meßfehler des Elektrizitätsfehlers 2 sofort erkannt werden, kann die Eichgültigkeit dieses Zählers praktisch auf unbestimmte Zeit gelten, und zwar bis tatsächlich ein Meßfehler auftritt und angezeigt wird. Nacheichungen nach Ablauf einer starr festgelegten Eichgültigkeit können entfallen. Weiterhin erlaubt die erfindungsgemäße Ausbildung auch eine vereinfachte Prüfung von Elektrizitätszählern 2.

Die Erfindung wurde voranstehend an einem Ausführungsbeispiel beschrieben. Es versteht sich, daß zahlreiche Änderungen sowie Abwandlungen möglich sind, ohne daß dadurch der der Erfindung zugrundeliegende Erfindungsgedanke verlassen wird.

**Bezugszeichenliste**

| | |
|---|---|
| 1 | Sternpunkt |
| 2 | Elektrizitätszähler |
| 3 | Meßwerk |
| 4 | Microcontroller bzw. Signalprozessor |
| 5 | Anzeigeelement |
| 6 | Anzeigesegment |
| $L_1$, $L_2$, $L_3$ | Phasenleiter |
| N | Null-Leiter |
| $Z_1$, $Z_2$, $Z_3$ | komplexe Last |
| $U_1$, $U_2$, $U_3$ | Phasenspannung |
| $U_{12}$, $U_{23}$, $U_{31}$ | Außenspannung |
| $I_1$, $I_2$, $I_3$ | Phasenstrom |
| $I_N$ | Null-Leiterstrom |

**Patentansprüche**

**1.** Elektrizitätszähler für Vier-Leiteranlagen mit drei

Phasen-Leitern ($L_1$, $L_2$, $L_3$) und einem Null-Leiter (N), wobei der Elektrizitätszähler (2) wenigstens ein Meßwerk (3) zur Messung der zur Bestimmung des Schein- und/oder Blind- und/oder Wirkleistungsverbrauchs notwendigen Meßgrößen, nämlich Spannungen, Phasenströme und Phasenwinkel aufweist sowie unter Verwendung der von diesem Meßwerk erzeugten Meßwerte seine Funktionstüchtigkeit selbst überwacht,

**dadurch gekennzeichnet, .**

**daß** das Meßwerk (3) auch zur Messung des im Null-Leiter (N) fließenden Stromes ($I_N$) und dessen Phasenwinkel ausgebildet ist,

**daß** im Meßwerk (3) oder in einen von diesem Meßwerk angesteuerten Signalprozessor (4) zur Überprüfung der Funktionstüchtigkeit des Zählers ein erstes Prüfsignal durch eine vektorielle Addition sämtlicher Phasenströme ($I_1$, $I_2$, $I_3$) und des Null-Leiterstromes ($I_N$) sowie ein zweites Prüfsignal durch eine vektorielle Addition der zwischen den Phasenleitern ($L_1$, $L_2$, $L_3$) anliegenden Außenspannungen ($U_{12}$, $U_{23}$, $U_{31}$) gebildet werden, und

**daß** vom Signalprozessor (4) ein einen Gerätefehler anzeigendes Fehlersignal dann erzeugt wird, wenn die Abweichung eines der beiden Prüfsignale von einem zugehörigen Sollwert außerhalb eines vorgegebenen Toleranzbereichs liegt.

2. Elektrizitätszähler nach Anspruch 1, **dadurch gekennzeichnet, daß** die Prüfsignale derart gebildet sind, daß der jeweilige Sollwert der Wert Null ist.

3. Elektrizitätszähler nach Anspruch 1 oder 2, **dadurch gekennzeichnet, daß** von dem Meßwerk (3) die Phasenspannungen ($U_1$, $U_2$, $U_3$) zwischen den Phasenleitern ($L_1$, $L_2$, $L_3$) und dem Null-Leiter (N) gemessen werden, und daß im Meßwerk (3) oder in dem Signalprozessor (4) aus diesen Phasenspannungen die Außenspannungen ($U_{12}$, $U_{23}$, $U_{31}$) durch vektorielle Subtraktion gebildet werden.

## Claims

1. Electricity meter for four-wire systems with three phase conductors ($L_1$, $L_2$, $L_3$) and a neutral conductor (N), wherein the electricity meter (2) has at least one measuring unit (3) for measuring the measurement variables necessary for determining the apparent and/or reactive and/or active power consumption, namely voltages, phase currents and phase angles, and [wherein] using the measurement values produced by this measuring unit, it monitors its functional soundness itself,

**characterised in that**

the measuring unit (3) is also designed to measure the current (IN) flowing in the neutral conductor (N) and its phase angle,

that in the measuring unit (3) or in a signal processor (4) controlled by this measuring unit (3), to check the functional soundness of the meter, a first test signal is formed through a vectorial addition of all phase currents ($I_1$, $I_2$, $I_3$) and of the neutral conductor current (IN), as well as a second test signal through a vectorial addition of the external voltages ($U_{12}$, $U_{23}$, $U_{31}$) that are present between the phase conductors ($L_1$, $L_2$, $L_3$), and

that the signal processor (4) produces an error signal that indicates a device error if the deviation of one of the two test signals from a corresponding reference values lies outside a given tolerance range.

2. Electricity meter in accordance with claim 1, **characterised in that** the test signals are formed such that the respective reference value is zero.

3. Electricity meter in accordance with claim 1 or 2, **characterised in that** the measuring unit (3) measures the phase voltages ($U_1$, $U_2$, $U_3$) between the phase conductors ($L_1$, $L_2$, $L_3$) and the neutral conductor (N), and that in the measuring unit (3) or in the signal processor (4), from these phase voltages the external voltages ($U_{12}$, $U_{23}$, $U_{31}$) are formed through vectorial subtraction.

## Revendications

1. Compteur d'électricité pour des installations à quatre conducteurs avec trois conducteurs de phase ($L_1$, $L_2$, $L_3$) et un conducteur neutre (N), le compteur électrique (2) présentant au moins un système de mesure (3) pour mesurer les grandeurs nécessaires pour déterminer la consommation apparente et / ou l'énergie réactive et / ou la puissance réelle, à savoir les tensions, les courants de phase et les angles de phase et surveillant lui-même sa capacité de fonctionnement en utilisant les grandeurs produites par ce système de mesure, **caractérisé**

**en ce que** le système de mesure (3) est également conçu pour mesurer le courant ($I_N$) passant dans le conducteur neutre (N) et son angle de phase,

**en ce que** dans le système de mesure (3) ou dans un processeur de signal (4) activé par ce système de mesure, un premier signal de contrôle est formé par une addition vectorielle de tous les courants de phase ($I_1$, $I_2$, $I_3$) et du courant du conducteur neutre ($I_N$) et un deuxième signal de contrôle est formé par une addition vectorielle des tensions externes ($U_{12}$, $U_{23}$, $U_{31}$) se trouvant entre les conducteurs de phase ($L_1$, $L_2$, $L_3$) pour vérifier la capacité de fonctionnement du compteur, et

**en ce que** un signal d'erreur indiquant une erreur du matériel est alors généré par le processeur de signal (4) quand l'écart d'un des deux signaux de contrôle par rapport à une valeur de consigne y afférente se situe en dehors d'une plage de tolérance prédéfinie.

2. Compteur d'électricité selon la revendication 1, **caractérisé en ce que** les signaux de contrôle sont formés de telle manière que la valeur de consigne en question est la valeur zéro.

3. Compteur d'électricité selon la revendication 1 ou 2, **caractérisé en ce que** les tensions de phase ($U_1$, $U_2$, $U_3$) entre les conducteurs de phase ($L_1$, $L_2$, $L_3$) et le conducteur neutre (N) sont mesurées par le système de mesure et **en ce que** les tensions externes ($U_{12}$, $U_{23}$, $U_{31}$) sont formées par soustraction vectorielle dans le système de mesure (3) ou dans le processeur de signal (4) à partir de ces tensions de phase.

## Fig.1

Fig. 2